# EUROPÄISCHE PATENTSCHRIFT

(11) **EP 3 250 893 B1**
(45) Veröffentlichungstag und Bekanntmachung des Hinweises auf die Patenterteilung: **21.11.2018**
(21) Anmeldenummer: 16701633.6
(22) Anmeldetag: 26.01.2016
(51) Int. Cl.: G01D 11/24, B81B 7/00

(54) **SENSOR MIT SYMMETRISCH EINGEBETTETEN SENSORELEMENTEN**
SENSOR WITH SYMETRICALLY EMBEDDED SENSOR ELEMENTS
CAPTEUR AVEC COMPOSANTS INCORPORES SYMETRIQUEMENT

(30) Priorität: 28.01.2015 DE 102015201482
(43) Veröffentlichungstag der Anmeldung: 06.12.2017
(73) Patentinhaber: Continental Teves AG & Co. OHG, 60488 Frankfurt am Main (DE)
(72) Erfinder: RAUKOPF, Svenja, 35329 Gemünden Felda - Hainbach (DE); SCHILLINGER, Jakob, 85080 Gaimersheim (DE); SCHULMEISTER, Michael, 64846 Groß-Zimmern (DE)
(86) Internationale Anmeldenummer: PCT/EP2016/051575
(87) Internationale Veröffentlichungsnummer: WO 2016/120272

(56) Entgegenhaltungen:
- DE-A1-102009 001 969
- DE-A1-102010 042 438
- DE-A1-102013 101 732

## Beschreibung

Die Erfindung betrifft einen Sensor zur Erfassung einer physikalischen Größe und eine Steuervorrichtung für ein Fahrzeug mit dem Sensor.
Aus der WO 2010 / 037 810 A1 ist ein Sensor zur Erfassung eines physikalischen Signals bekannt. Der Sensor weist einen Leadframe auf, der als Schaltungssträger die Sensorkomponenten des Sensors trägt und gleichzeitig verschaltet. Die Sensorkomponenten sind mit dem Leadframe in einem Schaltungsgehäuse eingehaust.

Aus der DE 10 2013 101 732 A1 ist ein weitere Sensor bekannt, wobei der thermomechanische Stress zwischen einem Sensorchip und einem Gehäusekörper reduziert wird.

Es ist Aufgabe der Erfindung, den bekannten Sensor zu verbessern.

Die Aufgabe wird durch die Merkmale des unabhängigen Anspruchs 1 gelöst. Bevorzugte Weiterbildungen sind Gegenstand der abhängigen Ansprüche.

Dem angegebenen Sensor liegt die Überlegung zugrunde, dass der eingangs genannte Sensor in einem Fahrzeug normalerweise in einem Schaltungsverbund verwendet wird. Dabei werden mehrere Komponenten zu einer übergeordneten Schaltung verbaut. Die übergeordnete Schaltung ist dabei in der Regel jedoch sehr groß, was den immer größer werdenden Anforderungen im Fahrzeugbau an die Miniaturisierung nicht gerecht wird.

Eine Lösung wäre, den Sensor nicht über einen eingangs genannten Leadframe (auch Stanzgitter genannt) zu fertigen, sondern das Sensorelement direkt auf einem Schaltungsträger aufzubringen, der die übergeordnete Schaltung realisiert. Hier stellt sich jedoch das Problem, dass das Sensorelement zur Sicherstellung einer hohen Lebensdauer in einem Schutzmaterial eingebettet werden muss. Dieses Schutzmaterial bringt jedoch aufgrund von Temperaturwechseln und anderen Einflüssen mechanischen Stress oder mechanische Spannungen in das Gesamtsystem ein, aufgrund derer diese das Gesamtsystem beschädigen und seine Lebensdauer reduzieren können.

Hier greift der angegebene Sensor mit dem Vorschlag an, den Sensor derart auszugestalten, dass der durch ein Element im Sensor hervorgerufene mechanische Stress ausgeglichen wird. Hierzu werden mindestens zwei Elemente des Sensors so angeordnet, dass sich der resultierende mechanische Stress in der Summe aufhebt. Das hierzu vorgesehene Ausgleichselement, mit dem die mechanische Spannungsfreiheit so gut wie möglich herbeigeführt werden soll, kann dabei ein für die Funktion des Sensors notwendiges Element oder ein redundantes Element sein, das eigens zur Neutralisierung des mechanischen Stresses in den angegebenen Sensor eingebracht wird.

Nach außen hin ist der Sensor so mechanisch spannungsfrei, wodurch die Lebensdauer des angegebenen Sensors deutlich erhöht werden kann.

In einer Weiterbildung des angegebenen Sensors sind das Ausgleichselement und das den mechanischen Stress hervorrufende Element des Sensors symmetrisch, insbesondere punktsymmetrisch angeordnet. Durch die symmetrische Anordnung der beiden Elemente wird versucht, ein Idealzustand zu erreichen, bei dem der mechanische Stress möglichst vollständig ausgelöscht wird.
Das Ausgleichselement kann sich dabei stofflich von der Einbettmasse unterscheiden, indem es beispielsweise als Lack, als redundante Bohrung oder als Lunker in der Einbettmasse ausgeführt wird.
In einer zusätzlichen Weiterbildung des angegebenen Sensors kann das Ausgleichselement ein vom Sensorelement verschiedenes elektrisches Bauelement umfassen, und damit nicht redundant ausgeführt sein.
Ein derartiges, nicht redundantes Bauelement kann beispielsweise ein Filterelement zur Erhöhung der elektromagnetischen Verträglichkeit, EMV genannt, sein.

Gemäß einem weiteren Aspekt der Erfindung umfasst eine Steuervorrichtung für ein Fahrzeug zum Steuern eines Verhaltens des Fahrzeuges basierend auf einer erfassten physikalischen Größe, einen der angegebenen Sensoren zum Erfassen der physikalischen Größe.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden, wobei:
Fig. 1 eine schematische Ansicht eines Fahrzeuges mit einer Fahrdynamikregelung,
Fig. 2 eine Prinzipdarstellung eines Drehzahlsensors in dem Fahrzeug der Fig. 1,
Fig. 3 eine schematische Darstellung eines Lesekopfes des Drehzahlsensors der Fig. 2 in einem Zwischenproduktionszustand
Fig. 4 eine schematische Schnittansicht eines alternativen Lesekopfes,
Fig. 5 eine schematische Ansicht einer idealen, theoretischen Anordnung verschiedener Bauelemente für einen Lesekopf,
Fig. 6 ein Steuergerät aus einer ersten Perspektive,
Fig. 7 das Steuergerät aus Fig. 6 aus einer zweiten Perspektive,
Fig. 8 eine schematische Draufsicht auf einen linearen Positionssensor, und
Fig. 9 eine schematische Draufsicht auf einen alternativen linearen Positionssensor zeigen.

In den Figuren werden gleiche technische Elemente mit gleichen Bezugszeichen versehen und nur einmal beschrieben.

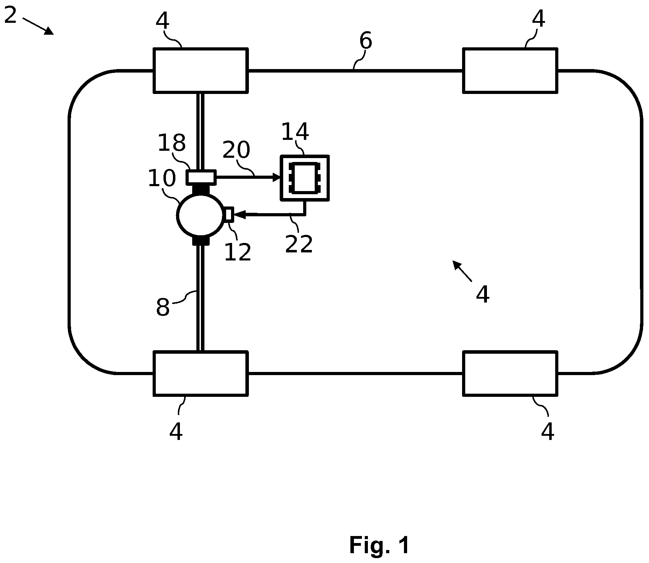

Es wird auf Fig. 1 Bezug genommen, die schematisch ein Fahrzeug 2 mit einem auf Rädern 4 getragenen Chassis 6 zeigt. Zwei der Räder 4 werden dabei über eine Achse 8 von einem Verbrennungsmotor 10 angetrieben. Die grundlegende Funktionsweise eines Verbrennungsmotors ist an sich bekannt und soll daher nachstehend nicht weiter thematisiert werden.

In an sich bekannter Weise, siehe beispielsweise DE 10 2012 206 552 A1 können die Ventilsteuerzeiten des Verbrennungsmotors 10 mit einem Nockenwellenversteller 12 eingestellt werden, um für eine bessere Treibstoffausnutzung in verschiedenen Drehzahlbereichen den Lastpunkt des Verbrennungsmotors 10 zu beeinflussen. Hierzu erfasst eine Nockenwellenansteuereinrichtung 14 über einen Drehzahlsensor 18 die Drehzahl 20 des Verbrennungsmotors 10 und steuert mit einem Steuersignal 22 den Nockenwellenversteller 12 basierend auf der erfassten Drehzahl 20 an. Die Erzeugung des Steuersignals 18 basierend auf der Drehzahl 20 ist an sich bekannt und soll nachstehend nicht weiter erläutert werden. Details hierzu finden sich in der einschlägigen Fachliteratur.

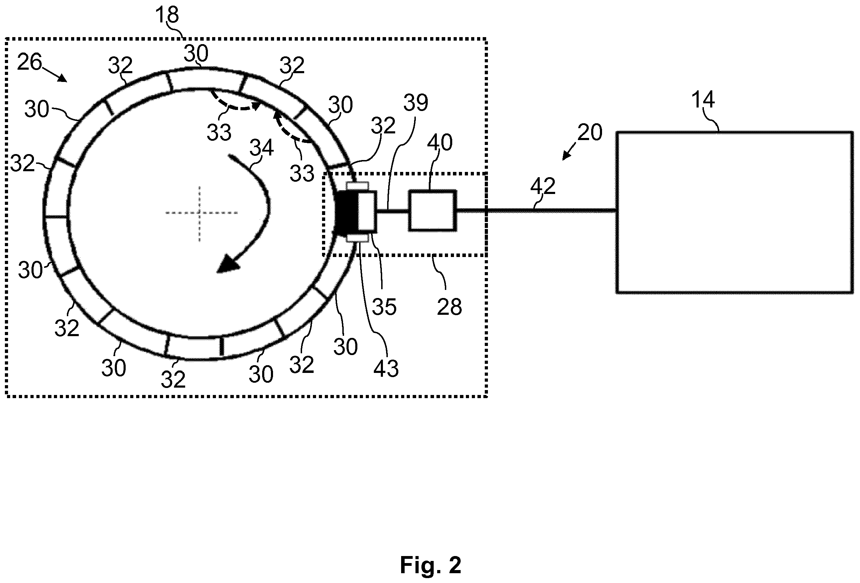

Der Drehzahlsensor 18 ist im Rahmen der vorliegenden Ausführung in einer besonderen Weise ausgebildet. Bevor hierauf näher eingegangen wird, soll der grundsätzliche Aufbau des Drehzahlsensors 18 selbst näher erläutert werden. Hierzu wird auf Fig. 2 Bezug genommen, die eine schematische Ansicht einer möglichen Ausführung des Drehzahlsensors 18 in dem Fahrzeug 2 der Fig. 1 zeigt.

Der Drehzahlsensor 18 ist in der vorliegenden Ausführung als aktiver Drehzahlsensor ausgeführt, der eine drehfest am nicht gezeigten Rotor des Verbrennungsmotors 10 befestigte Encodersscheibe 26 und einen ortsfest zum Chassis 6 befestigen Lesekopf 28 umfasst.

Die Encoderscheibe 26 besteht in der vorliegenden Ausführung aus aneinandergereihten Magnetnordpolen 30 und Magnetsüdpolen 32, die gemeinsam ein mit einem beispielhaften Pfeil angedeutetes magnetisches Encoderfeld 33 erregen. Dreht sich die Rotor des Verbrennungsmotors 10 befestigte Encoderscheibe 26 mit diesem in eine Drehrichtung 34, dreht sich das magnetische Encoderfeld 33 so mit.

Der Lesekopf 28 umfasst in der vorliegenden Ausführung einen Messfühler 35, der in Abhängigkeit der Bewegung des magnetischen Encoderfeldes 17 ein elektrisches Gebersignal 39 erzeugt. Hierzu kann jedes beliebige Messprinzip herangezogen werden, wie beispielsweise ein Messprinzip basierend auf dem magnetoresistiven Effekt. Das elektrische Gebersignal 39 ist damit von der zu erfassenden Drehzahl 20 abhängig.

Das Gebersignal 39 kann dann in einer im Lesekopf 28 angeordneten Signalverarbeitungsschaltung 40 aufbereitet werden. In der Regel wird hier aus dem Gebersignal 39 ein Pulssignal 42 erzeugt, wobei das Pulssignal 42 über einen vorbestimmten Zeitabschnitt eine Anzahl von Pulsen umfasst, die von der zu erfassenden Drehzahl abhängig ist. Dieses Pulssignal 42 wird dann an die Nockenwellensteuereinrichtung 14 ausgegeben, die dann die Drehzahl 20 durch Zählen der Pulse in dem Pulssignal 42 ableiten kann.

Weil durch den Verbrennungsmotor 10 in an sich bekannter Weise nicht unbeachtliche Störfelder auftreten, ist in dem Lesekopf 28 ein Stützmagnet 43 angeordnet, der diesen Störfeldern entgegenwirkt und so eine Erfassung der Drehzahl 20 mit niedrigen Toleranzen ermöglicht. Der Stützmagnet 43 sollte daher entsprechend stark gewählt werden, um den Störfeldern ausreichend entgegenwirken zu können.

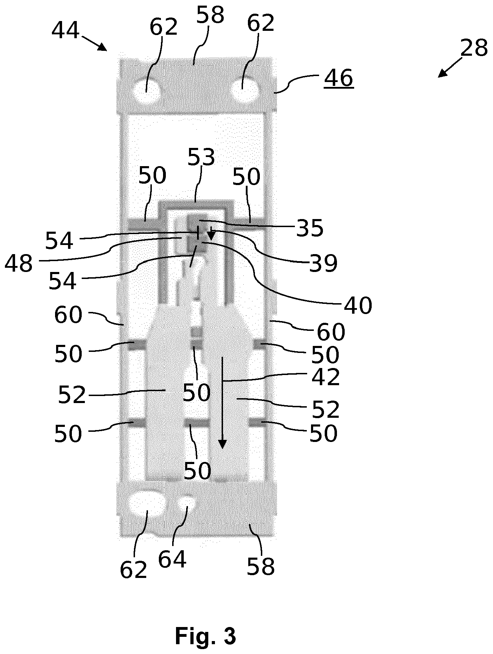

Herkömmlich wird der Lesekopf 28 auf einem Leadframe ausgeführt, wie er beispielsweise aus dem eingangs genannten Stand der Technik WO 2010 / 037 810 A1 bekannt ist. Ein derartiger Leadframe ist beispielsweise in Fig. 3 gezeigt und mit dem Bezugszeichen 44 referenziert. Der Leadframe 44 umfasst einen Halterahmen 46, eine Bestückinsel 48, auf der der Lesekopf 28 gehalten und verschaltet ist, zwei Dambars 50 und zwei Kontaktanschlüsse 52. Dabei halten die Dambars 50 die Kontaktanschlüsse 52 direkt und die Bestückinsel 48 über einen Hilfsrahmen 53 am Halterahmen 46. In dem Leadframe 44 sind der Halterahmen 46, die Bestückinsel 48, die Dambars 50, die Kontaktanschlüsse 52 und der Hilfsrahmen 53 als einstückiges Stanzteil oder Stanzrahmen ausgebildet, in dem die zuvor genannten Elemente durch Stanzen aus einem elektrisch leitfähigen Blech geformt werden.

Auf der Bestückinsel 48 wird im Rahmen der vorliegenden Ausführung der Messfühler 35, beispielsweise in Form eines magnetoresistiven Elements und die Signalauswerteschaltung 40 aufgebracht und elektrisch beispielsweise durch Löten oder Verkleben kontaktiert. Der Messfühler 35 und die Signalauswerteschaltung 40 sind dabei ferner über einen Bonddraht 54 miteinander verbunden, so dass über die Bestückinsel 48 und den Bonddraht 54 zwischen Messfühler 35 und der Signalauswerteschaltung 40 das Probesignal 39 übertragen werden kann.

Die Bestückinsel 48 ist in der vorliegenden Ausführung über direkt mit einem der beiden Kontaktanschlüsse 52 verbunden, während der andere der beiden Kontaktanschlüsse 52 von der Bestückinsel 48 galvanisch getrennt und mit der Signalauswerteschaltung 40 über einen weiteren Bonddraht 54 verbunden ist. Auf diese Weise kann über die beiden Kontaktanschlüsse 56 das Datensignal 42 aus der Signalauswerteschaltung 40 ausgegeben werden.

Der Halterahmen 46 weist im Rahmen der vorliegenden Ausführung zwei parallel zueinander verlaufende Transportsteifen 58 auf, die über Verbindungsstege 60 miteinander verbunden sind. Auf dem Transportstreifen 58 sind dabei Transportlöcher 62 ausgebildet, in die ein nicht weiter dargestelltes Transportwerkzeug eingreifen und den Leadframe 44 bewegen kann. Ferner ist auf dem Transportstreifen 58 ein Indexloch 64 ausgebildet, mittels dem die Lage des Leadframes 44 beim Transport bestimmt und damit geregelt werden kann.

Zum Schutz des Lesekopfes 28 kann um die den Lesekopf 28 tragende Bestückinsel 48 und einen Teil der Kontaktanschlüsse 52 ein Gehäuse ausgebildet werden. Das Gehäuse kann beispielsweise als Schutzmasse um den Lesekopf 28 ausgebildet werden, wozu der Kürze halber auf den einschlägigen Stand der Technik, wie beispielsweise die DE 10 2008 064 047 A1 verwiesen wird.

Dieser Lesekopf 28 muss nun zumindest elektrisch an die Nockenwellenansteuereinrichtung 14 angebunden werden, damit das Pulssignal 42 an diese übertragen werden kann. Die hierzu erforderlichen elektrischen Anbindungsprozesse erhöhen hierbei nicht nur den Fertigungsaufwand, die so entstehende Anbindung stellt grundsätzlich sowohl elektrische als auch mechanisch eine Fehlerquelle dar, aufgrund derer der Lesekopf 28 und damit der gesamte Drehzahlsensor 18 ausfallen kann.

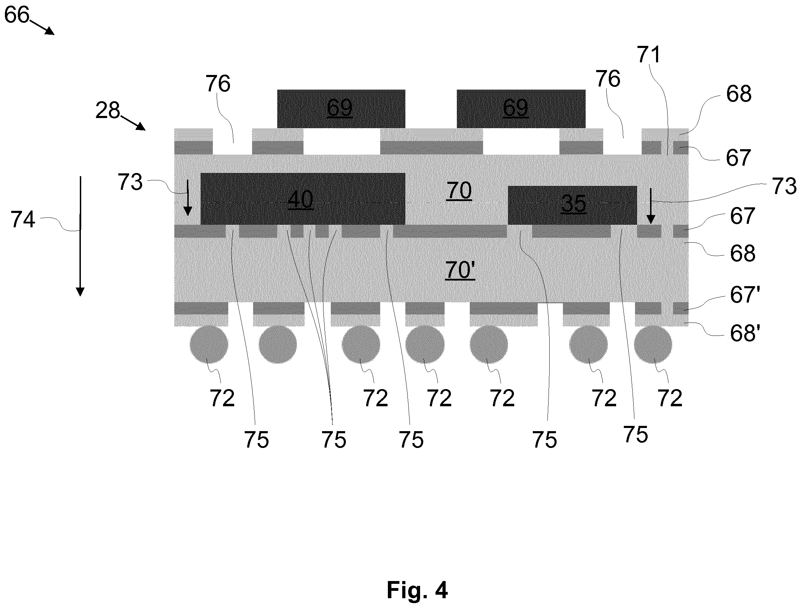

Hier greift das Ausführungsbeispiel mit dem Vorschlag an, den Lesekopf 28 des Drehzahlsensors 18 in einem Leiterplattenmodul einzubetten. Ein derartiges Leiterplattenmodul soll nachstehend ausgehend von der Fig. 4 näher erläutert werden, in der es in einer Schnittdarstellung mit dem Bezugszeichen 66 versehen ist.

Das Leiterplattenmodul 66 umfasst mehrere übereinander gestapelte Isolierschichten 67, auf denen Leiterbahnen 68 aufgetragen sind. Auf den Leiterbahnen 68 oder auf den Isolierschichten 67 sind die einzelnen, den Lesekopf 28 des Drehzahlsensors 18 konstituierenden Bauelemente 35, 40 getragen, zu denen neben dem bereits erwähnten Messfühler 35 und der bereits erwähnten Signalverarbeitungsschaltung 40 auch Filterelemente 69, wie passive Bauelemente gehören können, die die elektromagnetische Verträglichkeit des Lesekopfes 28 und damit des Drehzahlsensors 18 steigern.

Der Messfühler 35 und die Signalverarbeitungsschaltung 40 sind in der vorliegenden Ausführung zwischen zwei Isolierschichten 67 des Leiterplattenmoduls 66 in einer Einbettmasse 70 eingebettet. Auf diese Weise sind diese Elemente vor äußeren Einflüssen geschützt. Die einzelnen Schichten können elektrisch über Kontaktierungsbohrungen 71 miteinander verbunden werden. Ferner können an dem Leiterplattenmodul 66 Lötstellen 72 vorhanden sein, um das Leiterplattenmodul 66 elektrisch an eine übergeordnete Schaltung anzubinden.

Problematisch an der Einbettung gemäß Fig. 4 ist jedoch, dass sich individueller mechanischer Stress 73, der durch die einzelnen mechanischen Bauelemente 35, 40, 69 beispielsweise durch Temperaturbewegungen hervorgerufen wird, zu einem mechanischen Gesamtstress 74 summiert, der wiederrum das Leiterplattenmodul 66 beispielsweise verformen kann. Durch diese Verformung können sich unter anderem die Lötstellen 72 von der übergeordneten Schaltung lösen, und zu einem Ausfall des Lesekopfes 28 und damit Drehzahlsensors 18 führen.

Hier greift das Ausführungsbeispiel mit dem Vorschlag an, das Leiterplattenmodul 66 möglichst symmetrisch ausführen, damit sich der durch die einzelnen Bauelemente 35, 40, 69 hervorgerufene individuelle mechanische Stress 73 gegenseitig auslöscht und so den mechanischen Gesamtstress 74 minimiert. Hierzu sind in dem Leiterplattenmodul 66 verschiedene Ausgleichselemente vorhanden, die einem individuellen mechanischen Stress 73 entgegenwirken können. Es ist nicht zwingend notwendig alle gezeigten Ausgleichselemente in dem Leiterplattenmodul 66 tatsächlich zu realisieren, um den Gedanken hinter der Ausführung umzusetzen. Die einzelnen gezeigten Ausgleichselemente sollen lediglich beispielhaft verdeutlichen, wie die Bauelemente in dem Leiterplattenmodul 66 symmetrisch angeordnet werden können, um den mechanischen Gesamtstress unterhalb einer bestimmten, vertretbaren Grenze zu halten.

Zum einen ist es möglich, als Ausgleichselement eine redundante Leiterbahn 68' und eine redundante Isolierschicht 67' einzuführen, um die Leiterbahnanordnung in dem Leiterplattenmodul 66 symmetrisch auszubilden. Folglich wird hierbei auch eine redundante Einbettmasse 70' eingebracht, die sich von der Einbettmasse 70 unterscheiden kann oder aber auch gleich zu dieser gewählt werden kann.

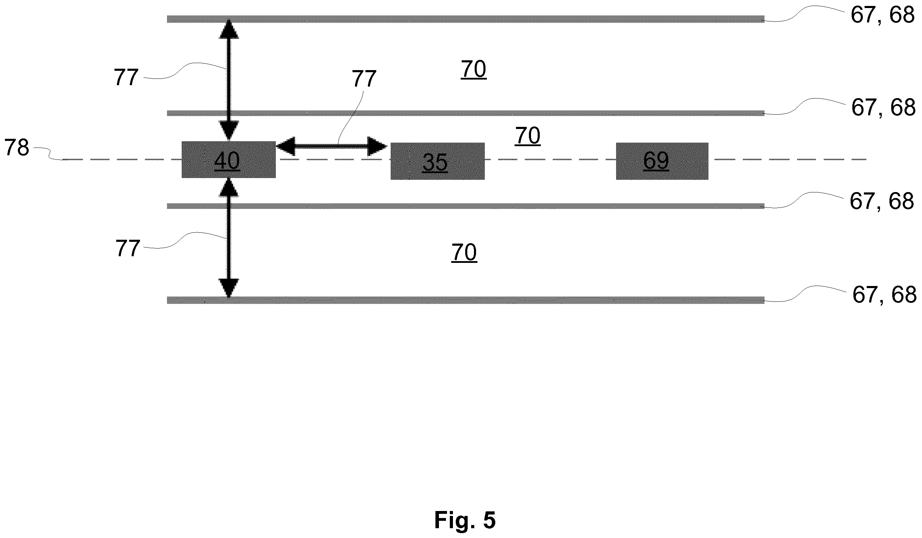

Als weitere Möglichkeit können der Messfühler 35 und die Signalverarbeitungsschaltung 40 zueinander symmetrisch aufgebaut sein. Vorteil hierbei ist es, dass als Ausgleichselemente keine redundanten Bauteile in das Leiterplattenmodul 66 eingebracht werden müssen. Um Unterschiede in der geometrischen, materiellen oder anderweitigen Beschaffenheit zwischen den beiden Bauelementen 35, 40 auszugleichen, werden die Kontaktierungen 75 der Leiterbahnen zu den einzelnen Bauelementen 35, 40, 69 unterschiedlich geometrisch dimensioniert, was in Fig. 4 durch unterschiedlich breite Kontaktierungen 75 am Messfühler 35 und an der Signalverarbeitungsschaltung 40 angedeutet ist.
Zudem können redundante Ausnehmungen 76 als Ausgleichselemente in das Leiterplattenmodul 66 eingebracht werden.
Der Idealfall des Leiterplattenmoduls 66 ist in Fig. 5 dargestellt. Hier sind alle Abstände 77 zwischen den einzelnen Elementen untereinander symmetrisch zu einer Symmetrieachse 78 ausgeführt. Praktisch ist dieses ideale Konzept jedoch schon allein deshalb nicht umzusetzen, weil die Bauelemente 35, 40, 69 dann nicht mehr mit den Leiterbahnen 68 kontaktiert werden könnten. Jedoch sollte der Idealfall bei der Konstruktion des Leiterplattenmoduls 66 versucht werden, so gut wie möglich zu erreichen.
Der Messfühler 35 sollte dabei möglichst zentral angeordnet werden, damit der individuelle mechanische Stress 73 auf diesen so gering wie möglich bleibt. Auf diese Weise können durch den individuellen mechanischen Stress 73 hervorgerufene Messfehler gering gehalten werden.
Durch das Einbetten der Bauelemente 40, 35 und passiven Komponenten 69 ist es möglich das entstehende Sensorsystem 28 deutlich zu miniaturisieren. Gleichzeitig können zusätzliche Komponenten von einem Steuergerät, wie beispielsweise die Nockenwellensteuereinrichtung 14 mit eingebettet werden. Hierbei wird auf dem Steuergerät, also im Ausführungsbeispiel der Nockenwellensteuereinrichtung 14 Leiterplattenplatz bzw. Bestückungsfläche reduziert.

Ferner ist es nicht notwendig, die einzelnen Bauelemente 35, 40 noch einmal in einem extra Verkapselungsschritt, beispielsweise durch Spritzpressen bei mit der oben im Rahmen der Fig. 3 genannten Schutzmasse zu umhüllen. Durch das vollflächige Umschließen der Bauelemente mit der Einbettmasse 70, beispielsweise in Form eines Harzes ist eine derartige Schutzmasse obsolet. Ein Harz bietet zugleich bessere thermische Eigenschaften zur Ableitung von Wärme erzeugt durch Verlustleistung der Komponenten als z. B. Luftkonvektion. Durch den Leiterplattenaufbau ist es sehr leicht möglich einfache EMV-Schutzmaßnahmen in den Leiterplatten-Lagenaufbau zu implementieren. Die Anbindung des Sensorsystems in Form des Lesekopfes 28 an die Leiterplatte des Steuergerätes, also der Nockenwellensteuereinrichtung 14 kann mechanisch robuster durch Flächenkontaktierung ausgeführt werden. Die elektrische Kontaktierung der Bauelemente 35, 40 des Lesekopfes 28 untereinander und an das Substrat über Drahtbondtechnologie entfällt. Die Kontaktierung kann über eine Strukturierung der Leiterbahnen 68, die beispielsweise als Kupferfolien ausgeführt sein können, (Innenlagen einer Leiterplatte) vorgenommen werden. Damit entsteht eine robustere und viel kürzere Signalverbindung.

Das Ausführungsbeispiel wurde an einem Drehzahlsensor 18 erläutert. In alternativen oder zusätzlichen Sensoren, in denen der zuvor erläuterte Gedanke zum Einsatz kommen kann, kann der Messfühler 35 beispielsweise Beschleunigungen, Drehraten und/oder Körperschall erfassen.

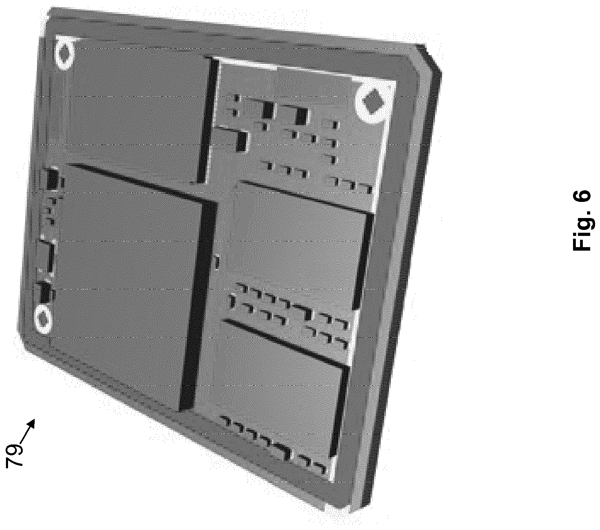

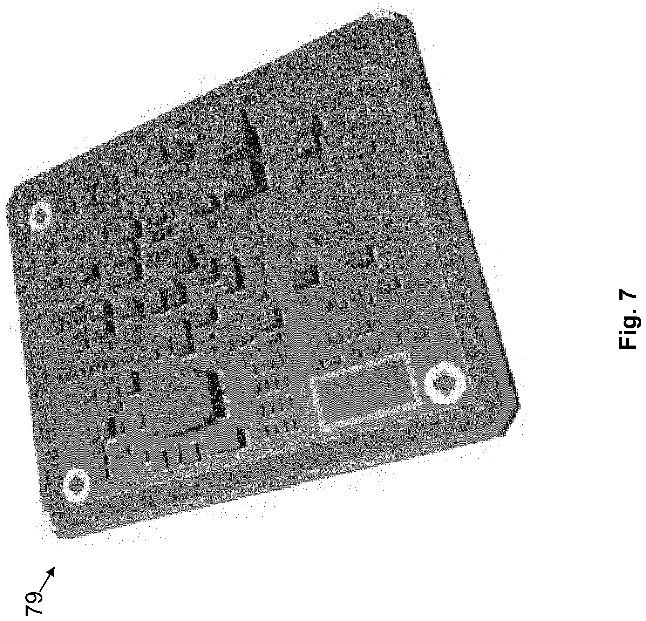

Alternativ kann der zuvor erläuterte Gedanke, wie bereits zuvor schon angedeutet, in ganzen Steuergeräten zum Einsatz kommen. Beispielsweise sei hierzu ein in Fig. 6 und 7 in einer perspektivischen Ansicht dargestelltes Car2X-Steuergerät 79 erwähnt. Hierbei handelt es sich um Steuergeräte, die an beispielsweise aus der WO 2010 / 139 526 A1 bekannten mobilen Ad-hoc-Netzen (Car2X genannt) teilnehmen können. Die Knoten derartige Car2X-Netze können bestimmte Straßenverkehrsteilnehmer wie Fahrzeuge oder andere Objekte im Straßenverkehr, wie Ampeln sein. Über diese Netzwerke können den am Car2X-Netzwerk beteiligten Straßenverkehrsteilnehmern Hinweise über Straßenverkehrszustände, wie Unfälle, Staus, Gefahrensituationen, ... bereitgestellt werden.

Durch den Einsatz des zuvor erläuterten Gedankens in ganzen Steuergeräten, wie dem zuvor genannten Car2X-Steuergerät, können Verwindungen und Verwölbungen der in dem Steuergerät implementierten Module reduziert werden.

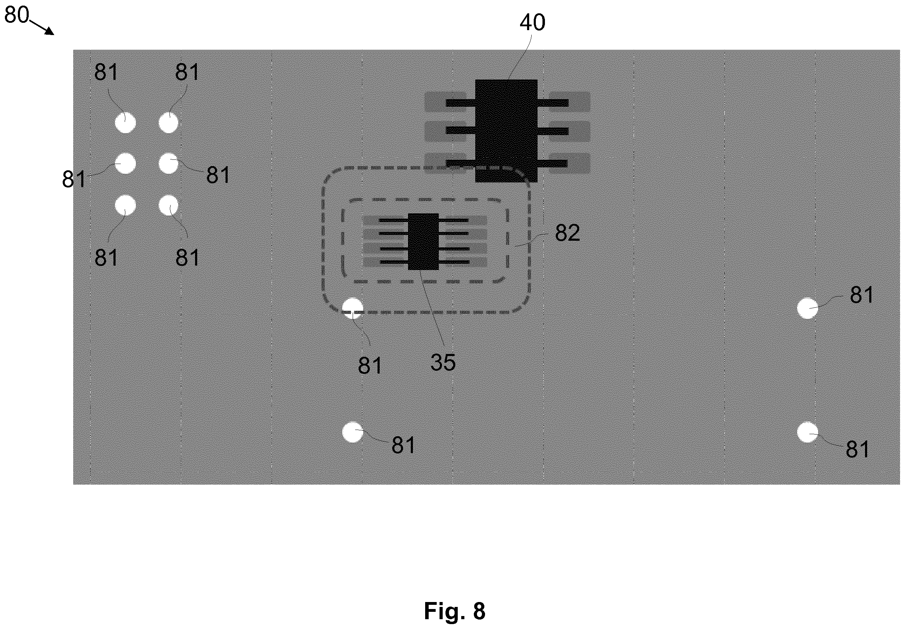

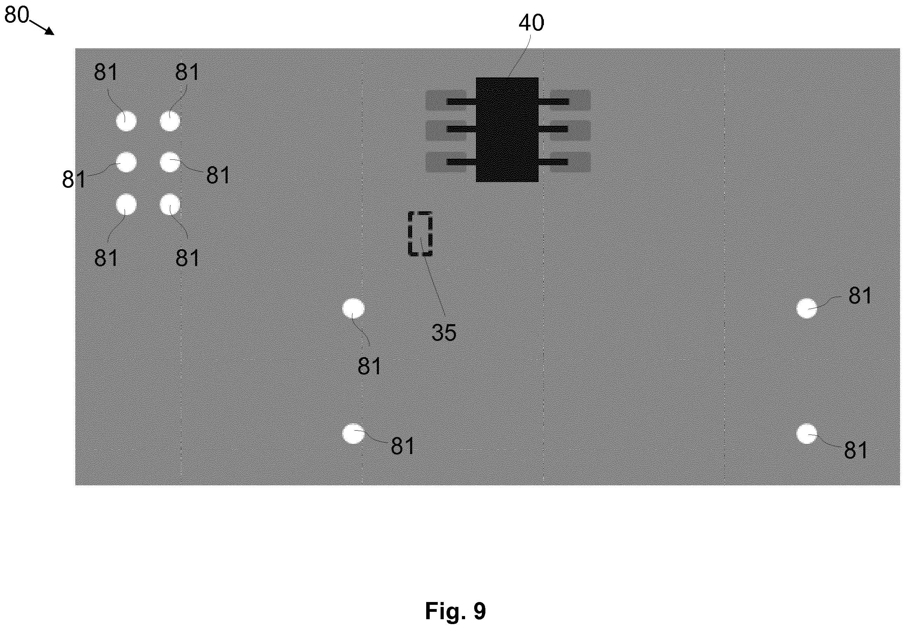

Ein weiterer Vorteil des zuvor angegebenen Gedankens soll nachstehend anhand der Fig. 8 und 9 erläutert werden. In diesen Figuren ist ein linearer Postionssensor 80, LIPS genannt, gezeigt, wie er beispielsweise aus der DE 10 2014 201 790 A1 bekannt ist.

Der LIPS 80 umfasst eine Leiterplatte aus Leiterbahnen 68 und Isolationsschicht 67, auf der mehrere Einpressstellen 81 für Press Fit-Verbindungen ausgebildet sind, um den Sensor an eine übergeordnete elektrische Einrichtung anzubinden.

Als Messaufnehmer 35 kann ein Spulenaufbau verwendet werden, wie er in der zuvor genannten Druckschrift offenbart ist. Ferner kann wieder eine Signalverarbeitungsschaltung 40 angeordnet werden, um Gebersignale aus dem Messaufnehmer 35 vor der Ausgabe an die übergeordnete elektrische Einrichtung anzupassen.

Der Messaufnehmer 35 in einem LIPS 80 stellt ein sogenanntes Fine Pitch-Bauelement dar, zu dessen Schutz in an sich bekannter Weise ein in Fig. 8 angedeuteter Lackierbereich 82 ausgebildet werden muss. Dieser Lackierbereich 82 kann durch Einbetten des Messaufnehmers 35 im Rahmen des zuvor erläuterten Gedankens wie in Fig. 9 gezeigt, komplett entfallen, wodurch die Miniaturisierung weiter erhöht werden kann.

## Patentansprüche

1. Sensor (28) zum Erfassen einer physikalischen Größe (20), umfassend:
- ein Sensorelement (35) zum Ausgeben eines von der physikalischen Größe (20) abhängigen elektrischen Signals (39),
- ein das Sensorelement (35) tragendes Substrat (67),
- eine das elektrische Signal (39) leitende Leiterbahn (68) auf dem Substrat (67), und
- eine Einbettmasse (70), in die das Sensorelement (35) vollständig und die Leiterbahn (68) wenigstens teilweise eingebettet sind,
- wobei in der Einbettmasse (70) wenigstens ein Ausgleichselement (40, 70', 76) ausgebildet ist, mit dem einem durch ein in der Einbettmasse (70) wenigstens teilweise eingebetteten Element des Sensors (28) hervorgerufenem mechanischen Stress (73) entgegengewirkt wird,
wobei das wenigstens teilweise in der Einbettmasse (70) eingebettete Element des Sensors (28) das Sensorelement (35) umfasst, wobei eine elektrische Kontaktierung (75) zwischen der Leiterbahn (68) und dem Sensorelement (35) von einer elektrischen Kontaktierung (75) des Ausgleichselementes (40, 70', 76) zu der Leiterbahn (68) oder einer anderen Leiterbahn verschieden ist, **dadurch gekennzeichnet, dass** der elektrische Kontaktierung des Sensorelements (35) sich von der elektrischen Kontaktierung des Ausgleichselementes (40, 70', 76) in seiner Größe unterscheidet, wobei der Größenunterschied derart ausgebildet ist, dass der mechanische Stress (73) weiter reduziert wird.

2. Sensor (28) nach Anspruch 1, wobei das Ausgleichselement (40, 70', 76) und das den mechanischen Stress (73) hervorrufende Element des Sensors (28) symmetrisch angeordnet sind.

3. Sensor (28) nach Anspruch 1 oder 2, wobei sich das Ausgleichselement (40, 70', 76) stofflich von der Einbettmasse (70) unterscheidet.

4. Sensor (28) nach einem der vorhergehenden Ansprüche, wobei das Ausgleichselement (40, 70', 76) ein vom Sensorelement (35) verschiedenes elektrisches Bauelement (40, 69) umfasst.

5. Sensor (28) nach Anspruch 4, wobei das vom Sensorelement (35) verschiedene elektrische Bauelement ein Filterelement (69) oder eine Signalverarbeitungsschaltung (40) ist.

6. Steuervorrichtung für ein Fahrzeug (2) zum Steuern eines Verhaltens des Fahrzeuges (2) basierend auf einer erfassten physikalischen Größe (20), umfassend einen Sensor (28) nach einem der vorstehenden Ansprüche zum Erfassen der physikalischen Größe (20).

## Claims

1. Sensor (28) for detecting a physical variable (20), comprising:
- a sensor element (35) for outputting an electrical signal (39) dependent on the physical variable (20),
- a substrate (67) supporting the sensor element (35),
- a conductor track (68) conducting the electrical signal (39) on the substrate (67), and
- an embedding compound (70), in which the sensor element (35) is completely embedded and the conductor track (68) is at least partially embedded,
- wherein at least one compensation element (40, 70', 76) is embodied in the embedding compound (70), by means of which compensation element a mechanical stress (73) induced by an element of the sensor (28) at least partially embedded in the embedding compound (70) is counteracted,
wherein the element of the sensor (28) at least partially embedded in the embedding compound (70) comprises the sensor element (35), wherein an electrical contact (75) between the conductor track (68) and the sensor element (35) is different from an electrical contact (75) of the compensation element (40, 70', 76) with the conductor track (68) or with another conductor track, **characterized in that** the electrical contact of the sensor element (35) differs from the electrical contact of the compensation element (40, 70', 76) in its size, wherein the size difference is designed in such a way that the mechanical stress (73) is further reduced.

2. Sensor (28) according to Claim 1,
wherein the compensation element (40, 70', 76) and the element of the sensor (28) which causes the mechanical stress (73) are arranged symmetrically.

3. Sensor (28) according to Claim 1 or 2,
wherein the compensation element (40, 70', 76) is made of a different material from the embedding compound (70).

4. Sensor (28) according to any of the previous claims,
the compensation element (40, 70', 76) comprising an electrical component (40, 69) which differs from the sensor element (35).

5. Sensor (28) according to Claim 4,
wherein the electrical component that differs from the sensor element (35) is a filter element (69) or a signal processing circuit (40).

6. Control device for a vehicle (2) for controlling a behavior of the vehicle (2) based on a detected physical variable (20), comprising a sensor (28) according to any one of the previous claims for detecting the physical variable (20).

## Revendications

1. Capteur (28) destiné à acquérir une grandeur physique (20), comprenant :
- un élément de détection (35) destiné à délivrer un signal électrique (39) dépendant de la grandeur physique (20),
- un substrat (67) qui porte l'élément de détection (35),
- une piste conductrice (68) sur le substrat (67) qui conduit le signal électrique (39), et
- une masse d'enrobage (70) dans laquelle l'élément de détection (35) est entièrement enrobé et la piste conductrice (68) au moins partiellement enrobée,
- au moins un élément de compensation (40, 70', 76) étant configuré dans la masse d'enrobage (70), lequel s'oppose à une contrainte mécanique (73) provoquée par un élément du capteur (28) au moins partiellement enrobé dans la masse d'enrobage (70),
l'élément du capteur (28) au moins partiellement enrobé dans la masse d'enrobage (70) comprenant l'élément de détection (35), la mise en contact électrique (75) entre la piste conductrice (68) et l'élément de détection (35) étant différente d'une mise en contact électrique (75) de l'élément de compensation (40, 70', 76) avec la piste conductrice (68) ou une autre piste conductrice, **caractérisé en ce que**
la mise en contact électrique de l'élément de détection (35) se différencie de la mise en contact électrique de l'élément de compensation (40, 70', 76) par sa taille, la différence de taille étant réalisée de telle sorte que la contrainte mécanique (73) est réduite davantage.

2. Capteur (28) selon la revendication 1, l'élément de compensation (40, 70', 76) et l'élément du capteur (28) qui produit la contrainte mécanique (73) étant disposés de manière symétrique.

3. Capteur (28) selon la revendication 1 ou 2, l'élément de compensation (40, 70', 76) se différenciant de la masse d'enrobage (70) au niveau du matériau.

4. Capteur (28) selon l'une des revendications précédentes, l'élément de compensation (40, 70', 76) comprenant un composant électrique (40, 69) différent de l'élément de détection (35).

5. Capteur (28) selon la revendication 4, le composant électrique différent de l'élément de détection (35) étant un élément de filtrage (69) ou un circuit de traitement de signal (40).

6. Dispositif de commande pour un véhicule (2) destiné à commander un comportement du véhicule (2) en se basant sur une grandeur physique (20) acquise, comprenant un capteur (28) selon l'une des revendications précédentes destiné à acquérir la grandeur physique (20).
